# FASCICULE DE BREVET EUROPEEN

(11) **EP 3 394 893 B1**
(45) Date de publication et mention de la délivrance du brevet: **05.07.2023**
(21) Numéro de dépôt: 16823245.2
(22) Date de dépôt: 19.12.2016
(51) Int. Cl.: H10K 30/83, H10K 39/36, H01L 27/146, H10K 30/81

(54) **DISPOSITIF OPTOELECTRONIQUE MATRICIEL PRESENTANT UNE ELECTRODE SUPERIEURE TRANSPARENTE**
OPTOELEKTRONISCHE MATRIXANORDNUNG MIT TRANSPARENTER OBERER ELEKTRODE
OPTOELECTRONIC ARRAY DEVICE HAVING A TRANSPARENT UPPER ELECTRODE

(30) Priorité: 23.12.2015 FR 1563284
(43) Date de publication de la demande: 31.10.2018
(73) Titulaire: Commissariat à l'Énergie Atomique et aux Énergies Alternatives, 75015 Paris (FR); ISORG, 38040 Grenoble Cedex 09 (FR); Trixell, 38430 Moirans (FR)
(72) Inventeur: BENWADIH, Mohammed, 94500 Champagny Sur Marne (FR); CHARLOT, Simon, 38620 Montferrat (FR); VERILHAC, Jean-Marie, 38500 Coublevie (FR); JOIMEL, Jérôme, 38040 Grenoble Cedex (FR); ROHR, Pierre, 38430 Moirans (FR)
(74) Mandataire: Atout PI Laplace
(86) Numéro de dépôt international: PCT/EP2016/081699
(87) Numéro de publication internationale: WO 2017/108670

(56) Documents cités:
- EP-A1- 0 721 219
- EP-A1- 2 528 097
- WO-A1-2016/092287
- DE-A1-102007 019 327
- US-A1- 2004 159 793
- US-A1- 2011 227 181
- US-A1- 2015 001 503
- US-B1- 6 215 164

## Description

L'invention porte sur un dispositif optoélectronique matriciel, de type matrice de photodétecteurs (imageur pixélisé). L'invention s'applique notamment, mais pas exclusivement, à la réalisation d'imageurs à rayons X matriciels de grande surface pour la radiologie médicale, le contrôle non destructif ou la sécurité, basés sur un principe de détection indirecte et utilisant, de préférence, des semi-conducteurs organiques.

De manière courante dans le cas de la détection X indirecte, un scintillateur (Oxysulfure de Gadolinium ou « Gadox » ; Csl :TI) est couplé via un film de couplage adhésif à une dalle qui détecte les photons visibles émis par le scintillateur lorsque ce dernier est irradié de photons X.

Cette dalle est composée d'une matrice active comportant jusqu'à plusieurs millions de pixels. Chaque pixel comprend au moins une photodiode et un transistor à couches minces (TFT, de l'anglais Thin-Film Transistor). La photodiode comprend deux électrodes, permettant de lui appliquer une tension de polarisation : une électrode inférieure, déposée sur le substrat diélectrique de la dalle, et une électrode supérieure, à l'opposé du substrat. Une électrode (typiquement l'électrode inférieure) de chaque photodiode est reliée à un conducteur de colonne par l'intermédiaire du transistor à couches minces, dont la grille est pilotée par un conducteur de ligne. Le réseau de conducteurs de lignes et de colonnes est ensuite connecté à des plots de reprise de contact situés à l'extérieur de la matrice. De cette façon, en connectant les plots extérieurs vers une carte électronique configurée avec des séquences de lecture appropriées, il est possible de lire chaque pixel individuellement et reconstituer ainsi une image bidimensionnelle (2D). L'autre électrode (typiquement l'électrode supérieure) est connectée à une tension de polarisation, la même pour tous les pixels.

La matrice active peut être basée sur des photodiodes organiques ou inorganiques, typiquement en silicium.

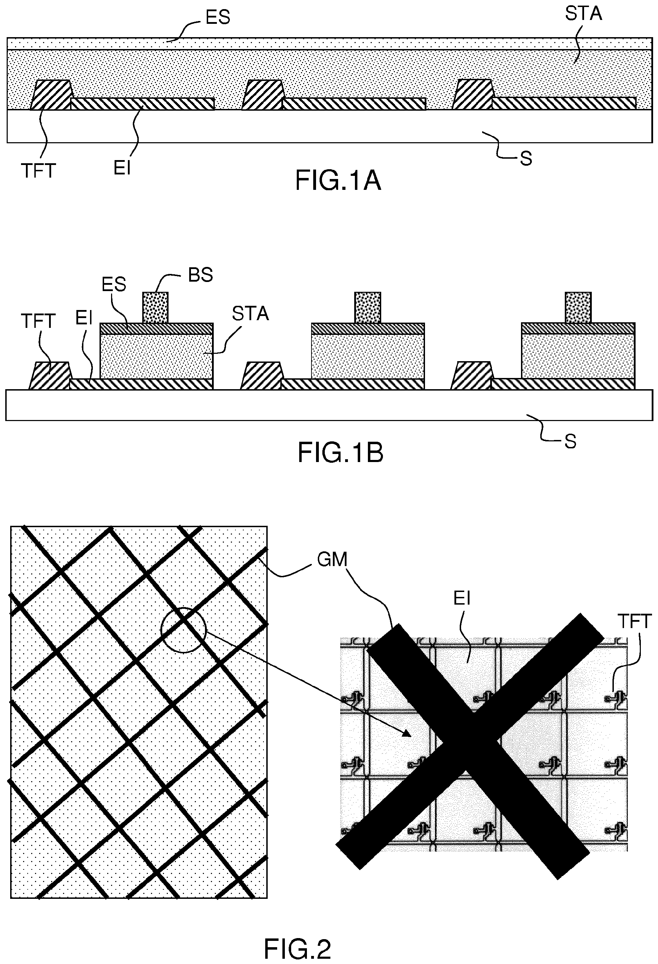

Les photodiodes organiques ont d'une part l'avantage de pouvoir être fabriquées sur de grandes surfaces grâce aux technologies de dépôts par voie liquide, et d'autre part de nécessiter d'un faible budget thermique de fabrication, ce qui permet de pouvoir les hybrider (intégrer) sur de nombreuses technologies de matrices existantes : a-Si:H (silicium amorphe), IGZO (Oxyde d'Indium-Gallium-Zinc), OTFT (TFT organiques), CMOS, etc. ainsi que sur substrats rigides (verre) ou souples (plastique). La figure 1A montre une vue en coupe d'une portion de matrice active à photodiodes organiques. Sur la figure, la référence S désigne le substrat diélectrique (ou recouvert d'une couche diélectrique), El et ES, respectivement, une électrode inférieure et supérieure de photodiode, STA une structure active (en l'espèce, une couche ou multicouche organique ou plus généralement comprenant au moins une couche contenant au moins un matériau organique) de photodiode, TFT un transistor à couches minces. On peut remarquer que les photodiodes ne doivent pas nécessairement être physiquement séparées les unes des autres, de telle sorte que la structure active STA peut être continue. De même, il est possible d'utiliser une électrode supérieure ES unique.

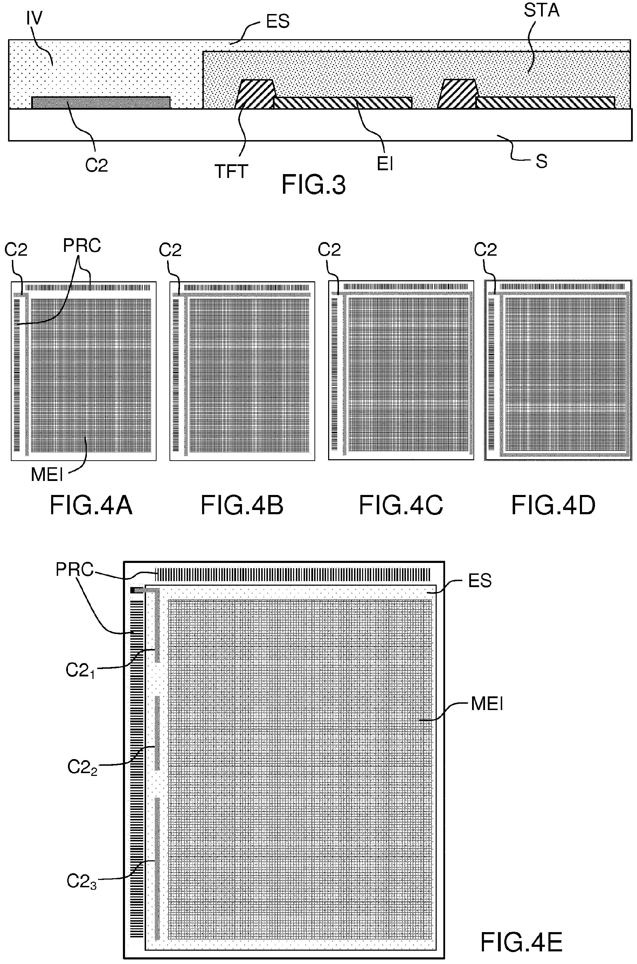

La figure 1B montre une vue en coupe d'une portion de matrice active à photodiodes inorganiques, par exemple en silicium. Cette fois les photodiodes doivent être physiquement séparées les unes des autres ; ainsi aussi bien la structure active STA que l'électrode supérieure ES sont discontinues. Pour assurer que les différentes portions de l'électrode supérieure soient à un même potentiel, elles sont interconnectées par des bus métalliques BS, généralement parallèles aux conducteurs de colonnes. Ces bus sont connectés entre eux sur au moins une extrémité, puis reliés au circuit extérieur via un ou plusieurs plots de reprise de contacts (voir les figures 4A - 4E, référence PRC).

Dans la suite on considérera principalement le cas d'une matrice à photodiodes organiques, mais l'invention s'applique également au cas des photodiodes inorganiques.

Afin de maximiser la résolution spatiale, la lumière incidente arrive généralement du côté de l'électrode supérieure, qui doit donc être transparente ou semi-transparente à la longueur d'onde de cette lumière. Dans le cas des photodiodes inorganiques, les bus BS sont opaques, mais suffisamment étroits pour n'absorber qu'une faible portion de la lumière incidente.

Différentes configurations d'électrodes supérieures conductrices et semi-transparentes ont déjà été utilisées dans le cadre des matrices actives couplées à un niveau de photodiodes organiques:
- Couches métalliques suffisamment minces pour être semi-transparentes (par exemple 2 nm Ca - 10 nm Ag) ; cependant la transmittance obtenue est peu satisfaisante, typiquement inférieure à 60%
- ITO (oxyde d'indium et étain) déposé par voie liquide ; cependant la résistivité est beaucoup trop élevée (de l'ordre de 1MΩ/□)
- Conducteur organique type PEDOT-PSS (poly(3,4-éthylènedioxythiophène) : polystyrène sulfonate) de sodium) ; la résistivité reste élevée (au moins 50Ω/□) si on souhaite maintenir une forte transmittance (80% ou plus).

Dans le cas des photodiodes inorganiques, on utilise le plus souvent une électrode supérieure en ITO. Là aussi, la résistivité est trop élevée, bien qu'elle soit moins importante que dans le cas des photodiodes organiques.

La configuration utilisant du PEDOT-PSS en tant qu'électrode supérieure est intéressante, en particulier dans le cas des photodiodes organiques. L'utilisation du PEDOT-PSS sur l'électrode supérieure permet en effet de réaliser un empilement de photodiode organique dans une structure dite inverse, dans laquelle l'électrode supérieure fait fonction d'anode. Ce type de structure permet de gagner en stabilité/fiabilité du dispositif ; en outre, le fait d'avoir l'anode sur le dessus de la matrice est avantageux dans le cadre des détecteurs X, dans la mesure où les électroniques de lecture actuelles des détecteurs X sont configurées pour collecter les électrons sur l'électrode inférieure (cathode) et les trous sur l'électrode supérieure (anode).

En contrepartie, le PEDOT-PSS a une résistivité plus élevé que les métaux, ce qui peut engendrer des artefacts sur les images lors de la lecture des matrices. D'autre part cette résistivité plus élevée que les métaux tend à limiter son utilisation aux dispositifs de petites surfaces uniquement ; or, il existe un besoin important pour des détecteurs de rayons X de grande surface (100 cm² ou plus).

Pour pouvoir l'utiliser sur des dispositifs de plus grandes surfaces, une solution, dérivée des cellules solaires inorganiques, et développée également dans le cadre des dispositifs de type cellule solaire organique (pour lesquelles de grandes surfaces de dispositifs sont nécessaires), a été d'utiliser un maillage GR de lignes conductrices, moins résistives que le PEDOT-PSS, disposé sur, ou sous, la surface de la couche de PEDOT-PSS (Figure 2). Dans ce cas, les charges électriques qui circulent dans le PEDOT-PSS sont transférées vers le point de maillage le plus proche et finissent par circuler dans ce dernier dans la mesure où sa résistance électrique est plus faible. En plus de sa capacité à diminuer la résistivité de l'électrode supérieure, le maillage, qui par définition est localisé dans l'espace, permet de connecter l'électrode supérieure vers le circuit extérieur tel que les plots de reprise de contact. Le maillage peut donc avoir une double fonction, celle de diminuer la résistivité de l'électrode supérieure et celle de connecter l'électrode supérieure vers un circuit extérieur. Les maillages sont généralement de nature métallique. Ils peuvent être déposés par évaporation, pulvérisation, électrochimie, microfluidique, ou par impression d'une encre conductrice, comme par exemple une encre Ag, par sérigraphie. De manière générale, ce maillage est réalisé avec un matériau opaque à la lumière, cependant sa structure en maille avec beaucoup de zones vides (sans matériaux) permet de conserver une bonne transmittance de l'électrode supérieure de manière moyennée sur la surface. La largeur des lignes conductrices du maillage est typiquement de l'ordre de quelques micromètres (µm) à plusieurs centaines de micromètres.

L'utilisation d'un tel maillage sur l'électrode supérieure dans le cas des détecteurs X n'est pas favorable. En effet, les dimensions des lignes conductrices du maillage sont du même ordre de grandeur que les dimensions des pixels (~80-150µm). Ainsi, la zone remplie de la maille va masquer (complètement ou en partie) certains pixels, avec pour conséquence inacceptable de rendre inactives certaines zones de la surface de la matrice. Cela est visible sur la partie de droite de la figure 2. L'utilisation d'un maillage bon conducteur a déjà été décrite pour des dispositifs optoélectroniques (US 2011/227181 et EP 2012/2528097), mais ce maillage présente quelques limitations au niveau de sa position par rapport à la structure active, sa connexion avec le substrat ne peut également pas traverser la structure active et enfin l'électrode supérieure n'est pas toujours continue.

Les documents US6215164, US2011227181 et US2015001503 divulguent des dispositifs optoélectroniques matriciels comprenant une matrice de photodétecteurs.

L'invention vise à surmonter les inconvénients précités de l'art antérieur. Plus particulièrement elle vise à pallier les inconvénients découlant de la résistivité des matériaux conducteurs transparents (PEDOT-PSS, ITO ou autres) utilisés pour la réalisation des électrodes supérieures des matrices actives, tout en préservant une transmittance maximale. Jusqu'à présent, seul le cas d'un imageur X a été considéré, mais le problème concerne également les imageurs optiques (ne présentant pas de scintillateur). Conformément à l'invention, ce but est atteint grâce à l'utilisation d'un « maillage » bon conducteur (et pouvant être opaque) porté par le substrat sans interposition de la structure active. Ce maillage peut être porté directement par le substrat, ou être situé en tout ou en partie au-dessus des transistors à couches mince (qui ne participent pas directement à la détection de la lumière et constituent ainsi des zones « aveugles »). Il peut être situé sous la structure active, ou dans une région périphérique du dispositif ou cette dernière n'est pas présente. En tout cas, il est relié à l'électrode supérieure transparente par des interconnexions verticales.

Un objet de l'invention est donc un dispositif optoélectronique matriciel comprenant les caractéristiques techniques de la revendication 1.

D'autres caractéristiques, détails et avantages de l'invention ressortiront à la lecture de la description faite en référence aux dessins annexés donnés à titre d'exemple et qui représentent, respectivement :
- Les figures 3 et 4A à 4E, différentes variantes d'un dispositif optoélectronique matriciel selon un premier mode de réalisation ne faisant pas partie de l'invention ;
- Les figures 5A à 5C, différentes variantes d'un dispositif optoélectronique matriciel selon un second mode de réalisation de l'invention ;
- Les figures 6A et 6B, un dispositif selon une variant d'un troisième mode de réalisation de l'invention ;
- La figure 6C, un dispositif selon une autre variante dudit troisième mode de réalisation de l'invention ;
- Les figures 7A et 7B, un dispositif selon une autre variante dudit troisième mode de réalisation de l'invention ;
- La figure 7C, un dispositif selon une autre variante dudit troisième mode de réalisation de l'invention ;
- La figure 8, un dispositif selon une autre variante dudit troisième mode de réalisation de l'invention ;
- Les figures 9A et 9B, un dispositif selon une autre variante dudit troisième mode de réalisation de l'invention ;
- La figure 10, un dispositif selon encore une autre variante dudit troisième mode de réalisation de l'invention ; et
- La figure 11, un imageur à rayons X basé sur le dispositif des figures 6A, 6B.

La figure 3 montre une vue en coupe d'un dispositif optoélectronique matriciel selon un premier mode de réalisation.

Le dispositif présente une structure semblable à celle illustrée sur la figure 1A, décrite plus haut : il comprend un substrat S, électriquement isolant (ou rendu isolant par une couche diélectrique), sur une surface duquel sont déposées des électrodes El, dites inférieures, formant une matrice ; des transistors à couches minces TFT connectés aux électrodes, une structure active STA (structure ou couche de photoconversion) de type photodiode organique recouvrant la matrice d'électrodes inférieures et une électrode supérieure transparente ES, par exemple en PEDOT-PSS. Il se différencie du dispositif de la figure 1A par la présence d'un élément conducteur C2 porté par la surface du substrat S, relié électriquement à l'électrode supérieure ES par une interconnexion verticale IV réalisée en matériau conducteur.

L'élément conducteur C2 est localisé en dehors du périmètre occupé par la matrice d'électrodes inférieures MEI et prend la forme d'un bus métallique qui longe tout ou une partie du périmètre de cette matrice. De préférence, il peut être situé entre la matrice MEI et des plots de reprise des contacts PRC (figures 4A à 4E). De manière générale, les matrices sont rectangulaires, mais pas nécessairement. Ainsi dans le cas où la matrice est rectangulaire, l'élément C2 longe tout ou une partie d'au moins un côté de la matrice (Figure 4A). De préférence, il longe deux côtés de la matrice (Figure 4B). Dans certains cas, il peut longer trois côtés de la matrice (Figure 4C) ou même faire le tour complet de la matrice (Figure 4D). De préférence, le bus C2 est continu, mais s'il existe des besoins particuliers, il peut être localement discontinu ; dans ce cas c'est l'électrode supérieure qui assure la continuité électrique au niveau des zones discontinues C2₁, C2₂, C2₃ (Figure 4E). Dans tous les cas, l'élément conducteur/bus C2 contacte électriquement au moins un plot de reprise de contact, ce qui permet de lui appliquer une tension électrique qui est transmise à l'électrode supérieure. Avantageusement, la résistance entre l'électrode supérieure et l'élément conducteur/bus C2 sera inférieure ou égale à 20 Ω.

Pour une dalle de détection X avec une matrice active de surface 284,16mm × 230,88mm, le bus C2 est avantageusement en forme de L, à savoir qu'il longe deux côtés de la matrice, et la surface de contact entre le bus C2 et l'électrode supérieure en PEDOT-PSS est comprise entre 140mm² et 600mm². De préférence, cette surface est de 520mm².

Dans le mode de réalisation de la figure 3, l'interconnexion verticale IV s'étend sur la tranche de la structure active STA et, si aucune précaution n'est prise, il pourrait arriver qu'il y ait une injection parasite de charges électriques de l'interconnexion verticale vers les proches électrodes inférieures voisines, et à travers la couche active. Pour éviter cela il est possible de choisir un matériau constitutif de l'interconnexion verticale présentant un travail de sortie adapté, c'est-à-dire tel que, lorsque le dispositif est polarisé de manière à assurer son fonctionnement normal (polarisation inverse - polarisation négative sur l'électrode d'anode avec la cathode à la masse - s'il s'agit d'une photodiode), il se forme une barrière de potentiel entre l'interconnexion verticale et la structure STA empêchant l'injection de porteurs de l'interconnexion verticale vers ladite structure STA. La hauteur de cette barrière doit être d'au moins 0,3 eV et de préférence d'au moins 0,5 eV. Plus particulièrement :
- Si la structure active STA forme une photodiode et l'électrode supérieure ES est l'anode de cette photodiode, la barrière de potentiel entre l'interconnexion verticale et la structure active doit être suffisante pour ne pas injecter d'électron de l'interconnexion vers la structure multicouche lorsque l'électrode supérieure est polarisée négativement et dans le noir.
- Si la structure active STA forme une photodiode et l'électrode supérieure ES est la cathode de cette photodiode, la barrière de potentiel entre l'interconnexion verticale et la structure active doit être suffisante pour ne pas injecter de trous de l'interconnexion vers la structure multicouche lorsque l'électrode supérieure est polarisée positivement et dans le noir.

Ces conditions sont satisfaites de manière automatique si l'interconnexion verticale est réalisée dans le même matériau que l'électrode supérieure ES (par exemple, PEDOT-PSS), solution qui est aussi la plus simple à mettre en oeuvre du point de vue technologique.

Bien entendu, les conditions suivantes doivent également être respectées pour éviter les courts-circuits :
- l'élément C2 ne doit pas être en contact électrique direct avec les électrodes inférieures El ou avec les conducteurs de ligne et de colonne ;
- l'électrode supérieure ES ne doit pas être en contact électrique direct avec les électrodes inférieures El ou avec les conducteurs de ligne et de colonne.

Cela vaut pour tous les modes de réalisation de l'invention.

Un détecteur matriciel selon ce mode de réalisation de l'invention a été réalisé en partant d'une dalle en verre de (0,7 × 311,4 × 251,4mm) comportant une matrice active de dimensions 284,16mm × 230,88mm. Cette matrice est composée de TFT a-Si :H dont chacun est connecté à une électrode inférieure El avec une surface en ITO. Le pas de la matrice est de 148 µm. La matrice est bordée sur deux côtés (côté plots de reprise de contact des lignes et côté plots de reprise de contact des colonnes), d'un bus conducteur C2 en forme de L (cf. la figure 4B) composé d'un multicouche 100nm de Cr - 20nm d'ITO en surface. Le Cr assure l'adhésion mécanique du bus et la conductivité du bus, tandis que l'ITO assure le contact électrique avec l'électrode supérieure. La largeur du bus est de 1mm, la branche du L côté plots de colonnes a une longueur de 231mm et la branche du L côté plots de lignes a une longueur de 290mm. Le bus est connecté à un plot de reprise de contact extérieur à la matrice. La distance entre le bus et le bord de la matrice est de 3mm. Une couche de ZnO de 30nm a été déposée par pulvérisation cathodique sur la surface des électrodes inférieures de la matrice pour diminuer le travail de sortie de l'ITO afin de lui conférer la propriété de cathode. Le ZnO déborde de la matrice de 0,5mm. Ensuite une couche de photoconversion, formant la structure active STA, a été déposée à la tournette dans un solvant de type 1,2 dichlorobenzène, avec une épaisseur sèche de 400nm après recuit thermique. Cette couche est un mélange nanostructuré entre un matériau donneur d'électron (Poly[2,1,3-benzothiadiazole-4,7-diyl[4,4-bis(2-ethylhexyl)-4H-cyclopenta[2,1-b:3,4-b']dithiophene-2,6-diyl]], connu comme PCPDTBT) et un matériau accepteur d'électron ([6,6]-phényl-C₆₁-butanoate de méthyle, connu comme [60]PCBM) avec un rapport massique de 1 :1. La couche de photoconversion recouvre toute la matrice et s'arrête 1mm au-delà de la couche de ZnO. Une couche de PEDOT-PSS a ensuite été déposée à la tournette sur la couche de photoconversion de manière à former une électrode supérieure ES. Cette couche de PEDOT-PSS a une épaisseur de 300nm, une résistivité de 240Ω/□, et une transmittance de 92% à la longueur d'onde de 520 nm, correspondant à l'émission d'un scintillateur en Csl :Tl ou Gadox. L'électrode supérieure ES en PEDOT-PSS vient contacter le bus Cr-ITO sur toute la surface prévue à cet effet. Une encapsulation composée d'un PSA (adhésif sensible à la pression, de l'anglais « Pressure Sensitive Adhesive ») barrière et d'un film barrière et ayant une épaisseur totale de 75µm a ensuite été laminée sur la surface du PEDOT-PSS de manière à recouvrir toute la surface couverte par les couches organiques (couche de photoconversion STA et couche de PEDOT-PSS forment l'électrode supérieure ES). Un adhésif double face (épaisseur 30µm) a été laminé sur la surface du film barrière. Sur cet adhésif a été laminé un scintillateur de Csl :TI dont les fibres ont été fait croitre sur un substrat d'Aluminium. Une passivation des bords du substrat a été réalisée en déposant un cordon de colle siliconée. Les plots de reprise de contact sur deux côtés de la dalle ont été connectés à une carte électronique type PCB (carte de circuit imprimé, de l'anglais Printed Circuit Board) comportant l'électronique de lecture de la matrice par l'intermédiaire de flexibles combinés à un adhésif de type ACF (Anisotropic Conductive Film, c'est-à-dire pellicule conductrice anisotrope) de manière à permettre l'acquisition d'une image numérique.

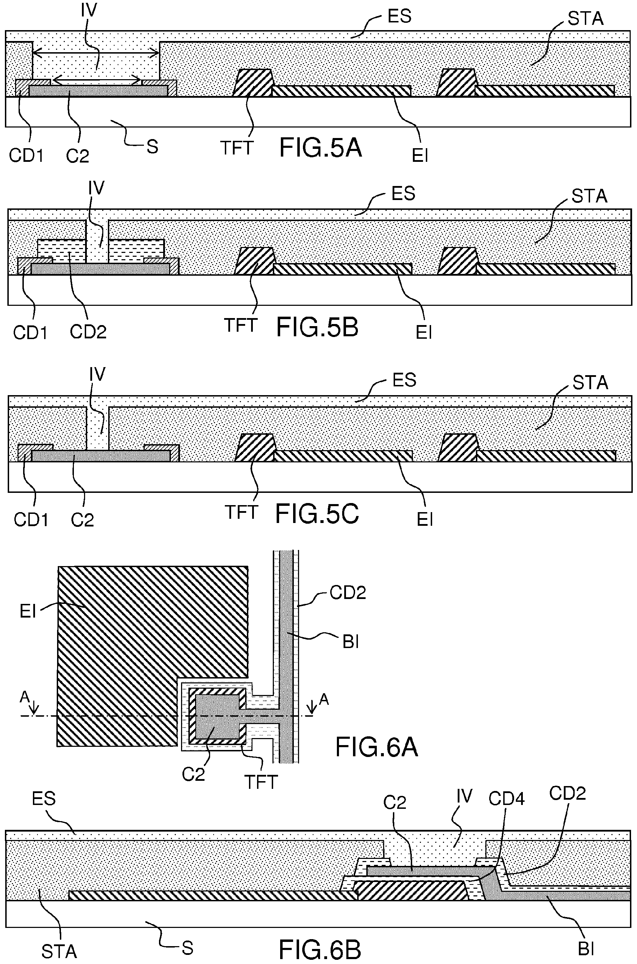

Les figures 5A à 5C montrent des vues en coupe de dispositifs optoélectroniques matriciels selon trois variantes d'un deuxième mode de réalisation de l'invention. Comme dans le cas de la figure 3, une interconnexion verticale IV relie l'électrode supérieure transparente ES à un élément conducteur C2 déposé sur le substrat et situé à l'extérieur de la matrice d'électrodes inférieures. Contrairement au cas de la figure 3, cependant, la structure active STA recouvre l'élément conducteur C2 et est donc traversée par l'interconnexion verticale IV.

Dans ce mode de réalisation il est important d'éviter qu'un contact direct entre la partie inférieure (proche du substrat) de la structure active STA et l'élément conducteur C2 - qui se trouve au potentiel de l'électrode supérieure ES - ne provoque l'apparition de courants électriques parasites vers les électrodes inférieures proches voisines, et à travers la couche active. Cela peut être obtenu, notamment, de trois façons illustrées par les figures 5A - 5C.

Premièrement, l'interconnexion verticale IV (qui, comme cela a été expliqué plus haut en référence à la figure 3, présente un travail de sortie adapté pour éviter toute injections de charges électriques parasites) peut être plus large que la surface supérieure non isolée de l'élément conducteur C2 de manière à séparer physiquement ce dernier de la structure active STA. Cette possibilité est illustrée sur la figure 5A.

Deuxièmement, une couche diélectrique CD2 peut recouvrir la surface supérieure de l'élément conducteur C2 de manière à l'isoler de la structure active STA. Cette couche diélectrique est traversée par l'interconnexion verticale IV. Cette possibilité est illustrée sur la figure 5B.

Troisièmement, l'élément conducteur C2 peut être réalisé en un matériau (exemple : Au dans le cas où l'électrode supérieure ES fait office d'anode) présentant un travail de sortie adapté pour permettre l'apparition d'une barrière de potentiel avec la structure active STA, tout comme le matériau de l'interconnexion verticale. Cette possibilité est illustrée sur la figure 5C.

Dans les trois variantes du deuxième mode de réalisation de l'invention illustrées sur les figures 5A à 5C, les bords de l'élément conducteur C2 sont recouverts d'une fine couche diélectrique CD1, qui n'est pas essentielle mais qui est généralement présente quand le niveau C2 n'est pas réalisé lors de la dernière étape de fabrication de la matrice.

Un détecteur matriciel selon ce mode de réalisation de l'invention, et plus précisément selon la configuration de la figure 5B, a été réalisé en partant d'une dalle en verre de (0,7 × 311,4 × 251,4mm) comportant une matrice active de dimensions 284,16mm × 230,88mm. Cette matrice est composée de TFT en IGZO dont chacun est connecté à une électrode inférieure El dont la surface est en Cr. Le pas de la matrice est de 80µm. La matrice est bordée sur 2 côtés (côté plots de reprise de contact des lignes et côté plots de reprise de contact des colonnes), d'un bus conducteur C2 en forme de L, composé d'un multicouche avec 100nm de TiW et 100nm d'ITO en surface. Le TiW assure l'adhésion mécanique du bus et sa conductivité ; l'ITO assure le contact électrique avec l'électrode supérieure. La largeur du bus est de 1mm, la branche du L côté plots de lignes a une longueur de 231mm, et la branche du L côté plots de lignes a une longueur de 290mm. Le bus est connecté aux plots de reprise de contact extérieurs à la matrice, en dix endroits. La distance entre le bus est le bord de la matrice est de 2mm. Dans les zones prévues pour le contact avec l'électrode supérieure, le bus est recouvert d'une couche diélectrique CD2 de type organique (résine négative SU8) de 1µm d'épaisseur. Une couche de photoconversion est déposée par enduction dans un solvant de type mésytilène, avec une épaisseur sèche de 200nm après recuit thermique. Cette couche est un mélange nanostructuré entre un matériau donneur d'électron (poly(3-hexylthiophene régio-régulier, connu comme P3HT RR) et un matériau accepteur d'électron (Di[1,4]methanonaphthaleno [1,2:2',3';56,60:2",3"][5,6]fullerène-C60-lh, connu comme ICBA) avec un rapport massique de 1 :2. La couche de photoconversion recouvre toute la matrice ainsi que la surface du bus périphérique. Des vias circulaires, avec un diamètre de 300µm et un espacement également de 300 µm, débouchant sur la couche en ITO du bus C2, ont été formés par ablation laser (excimère 248nm, 450mJ par impulsion) de la couche de photoconversion et de la résine SU8 au niveau de la surface du bus destinée à rentrer en contact avec l'électrode supérieure. Ensuite, une couche de PEDOT-PSS a été déposée à la tournette sur la couche de photoconversion pour former ladite électrode supérieure ES. La couche de PEDOT-PSS a une épaisseur de 300nm, une résistivité de 240Ω/□, et une transmittance de 92% à la longueur d'onde de 520 nm, correspondant à l'émission d'un scintillateur en Csl :TI ou en Gadox. Le PEDOT-PSS vient contacter le bus TiW-ITO à travers les vias prévus à cet effet. Une encapsulation composée d'une colle barrière et d'un film barrière et ayant une épaisseur totale de 75µm, a été laminée sur la surface du PEDOT-PSS de manière à recouvrir toute la surface couverte par les couches organiques (couche de photoconversion et couche de PEDOT-PSS). Un adhésif double face (épaisseur 30µm) a été laminé sur la surface du film barrière. Sur cet adhésif a été laminé un scintillateur de Gadox. Une passivation des bords du substrat a été réalisée en déposant un cordon de silicone. Les plots de reprise de contact sur deux côtés de la dalle ont été connectés à une carte électronique type PCB comportant l'électronique de lecture de la matrice par l'intermédiaire de flexibles combinés à un adhésif de type ACF de manière à permettre l'acquisition d'une image numérique.

Les figures 6A à 10 illustrent différentes variantes d'un troisième mode de réalisation de l'invention, dans lequel les interconnexions verticales IV traversent la structure active STA et viennent contacter un ou plusieurs éléments conducteurs C2 qui se trouvent à l'intérieur de la matrice active d'électrodes inférieures El et transistors TFT. Comme dans les modes de réalisation considérés plus haut, le ou chaque élément conducteur/bus C2 est relié électriquement à au moins un plot de reprise de contact, ce qui permet de lui appliquer une tension électrique qui est transmise à l'électrode supérieure. Les précautions décrites plus haut et destinées à éviter les injections parasites de porteurs dans la structure active depuis les interconnexions verticales les éléments conducteurs C2 s'appliquent également.

De manière avantageuse, ce mode de réalisation prévoit l'utilisation d'une pluralité d'éléments connecteurs C2 formant un maillage qui suit le maillage de la matrice à savoir les lignes et/ou les colonnes. De manière préférée, les éléments conducteurs C2 en contact avec les interconnexions verticales IV sont connectés entre eux par des bus Bl qui sont parallèles aux colonnes. Ces bus parallèles aux colonnes sont ensuite connectés électriquement entre eux en bout de colonnes, et sont reliés à un ou plusieurs plots de reprise de contact en périphérie de la matrice. Les bus sont déconnectés électriquement des lignes et colonnes de la matrice. Ils englobent des paquets de pixels ou de lignes ou colonnes. Par paquet, on entend des groupes de d'environ 1, 10, 100, 1000, 10000, 100000, 1000000, 10000000 et plus de pixels ou lignes ou colonnes.

Les figures 6A (vue par-dessus) et 6B (coupe A-A) illustrent le cas où un élément C2 est agencé au-dessus d'un transistor TFT, séparé de ce dernier et de la structure active STA par un matériau diélectrique CD4, qui peut être le même utilisé pour réaliser la couche isolante CD2, ou être un matériau différent. Ce mode de réalisation présente l'avantage de ne pas diminuer la surface utile de la matrice active, et donc l'efficacité de détection ou génération de la lumière. Dans ce cas, il peut y avoir jusqu'à un élément C2 en correspondance de chaque pixel, mais de préférence il y aura plutôt un élément C2 par paquet de 100, 1000, voire 10.000 pixels ou plus.

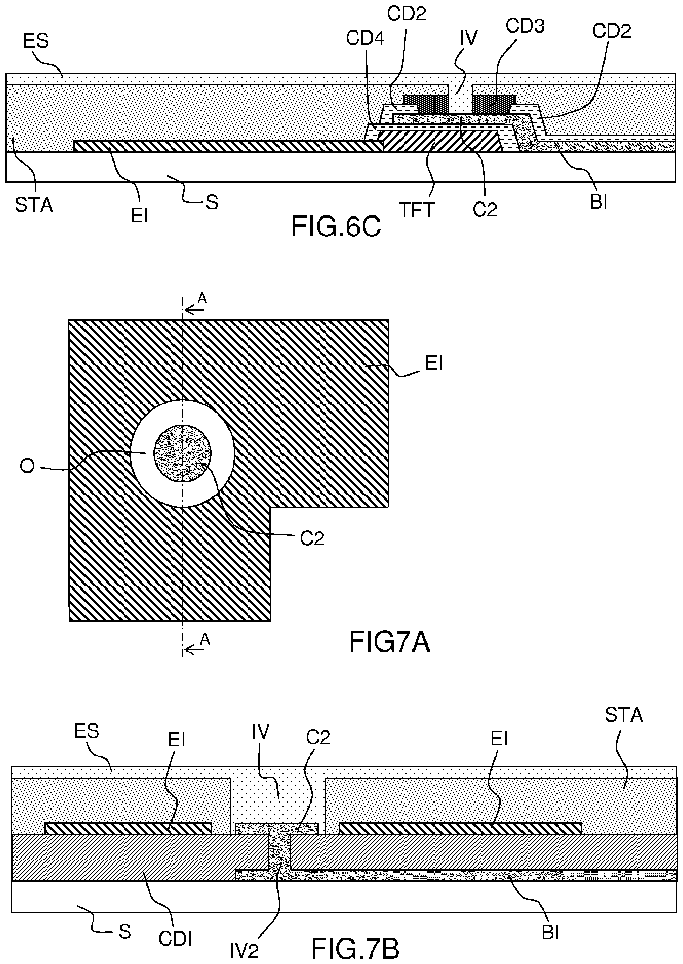

La figure 6C montre un dispositif semblable à celui des figures 6A et 6B dans lequel une couche diélectrique CD3 est utilisée pour éviter tout contact direct entre l'élément C2 et la structure active STA. Ce dispositif a été obtenu à partir d'une dalle en verre de (0,7 × 311,4 × 251,4mm) comportant une matrice active de dimensions 284,16mm × 230,88mm. Cette matrice est composée de TFT a-Si :H dont chacun est connecté à une électrode inférieure El dont la surface est en Al. Le pas de la matrice est de 150µm. A l'intérieur de la matrice est intégré un réseau secondaire d'éléments conducteurs C2. Ce réseau n'est pas connecté électriquement aux lignes et colonnes, mais est connecté à 10 plots de reprise de contact à l'extérieur de la matrice. Il se présentait sous la forme de bus Bl parallèles aux colonnes. Il y a un bus Bl toutes les 10 colonnes, et chaque bus Bl est connecté à 100 interconnexions verticales IV avec l'électrode supérieure. Le réseau C2 est un bi-couche Cr/ITO d'épaisseur 100nm/20nm. Pour réaliser les éléments conducteurs C2 on a utilisé la surface occupée par le TFT dans le pixel. Chaque partie de pixel en Cr/ITO dédiée à la zone de reprise de contact a été passivée par une résine diélectrique en SU8 d'épaisseur 500nm (référence CD3 sur la figure) afin d'éviter tout contact direct avec la couche de photoconversion (structure active STA) déposée ultérieurement. Ensuite la couche de photoconversion STA a été déposée à la tournette dans un solvant de type chlorobenzène avec une épaisseur sèche de 600nm après recuit thermique. Cette couche est un mélange nanostructuré entre un matériau donneur d'électron (PCDTBT) et un matériau accepteur d'électron ([60]PCBM) avec un rapport massique de 1 :1. Des vias passant à travers la couche de photoconversion et la résine diélectrique en SU8 ont été formés par ablation laser (excimère 248nm, 450mJ par impulsion) afin de pouvoir établir un contact électrique entre l'ITO de chaque élément C2 et l'électrode supérieure. Ensuite, une couche de PEDOT-PSS formant l'électrode supérieure ES a été déposée par filière en forme de fente (« slot-die ») sur la couche de photoconversion. La couche de PEDOT-PSS a une épaisseur de 1,1µm, une résistivité de 50Ω/□, et une transmittance de 73% à la longueur d'onde de 520 nm, correspondant à l'émission d'un scintillateur en Csl :Tl ou Gadox. Le PEDOT-PSS vient contacter les éléments C2 à travers les vias. Une encapsulation composée d'un PSA barrière et d'un film barrière et ayant une épaisseur totale de 75µm a été laminée sur la surface du PEDOT-PSS de manière à recouvrir toute la surface couverte par les couches organiques (couche de photoconversion et couche de PEDOT-PSS). Un adhésif double face (épaisseur 30µm) a été laminé sur la surface du film barrière. Sur cet adhésif a été laminé un scintillateur de Csl :TI dont les fibres ont été faites croitre sur un substrat d'Aluminium. Une passivation des bords du substrat a été réalisée en déposant un cordon de silicone. Les plots de reprise de contact sur deux côtés de la dalle ont été connectés à une carte électronique type PCB comportant l'électronique de lecture de la matrice par l'intermédiaire de flexibles combinés à un adhésif de type ACF de manière à permettre l'acquisition d'une image numérique. Les figures 7A (vue par-dessus) et 7B (coupe A-A) illustrent le cas où un élément C2 est agencé dans une ouverture O pratiquée dans une électrode inférieure El. Cette ouverture occupe, de préférence, une surface non supérieure à 10% de celle de l'électrode inférieure. La figure 7B montre que l'interconnexion verticale IV qui relie l'électrode supérieure ES à l'élément C2 est suffisamment large pour éviter tout contact entre cet élément et la structure active STA. Les bus d'interconnexion Bl reliant les éléments C2 entre eux sont enterrés : ils sont déposés directement sur le substrat S, alors que les électrodes inférieures El, les éléments C2 et la structure active STA sont réalisés au-dessus d'une couche diélectrique CDI déposée par-dessus. Des interconnexions verticales IV2 traversent cette couche diélectrique pour relier les éléments C2 aux bus Bl. Comme dans le cas des figures 6A - 6C il peut y avoir jusqu'à un élément C2 en correspondance de chaque pixel, mais de préférence il y aura plutôt un élément C2 par paquet de 1000, voire 10.000 pixels ou plus. La résistance entre l'électrode supérieure et les plots de reprise de contact sera d'autant plus faible que le nombre d'éléments C2 sera élevé, mais chaque élément C2 empiète sur la surface d'une électrode inférieure et réduit donc l'efficacité de génération ou détection de lumière du dispositif matriciel.

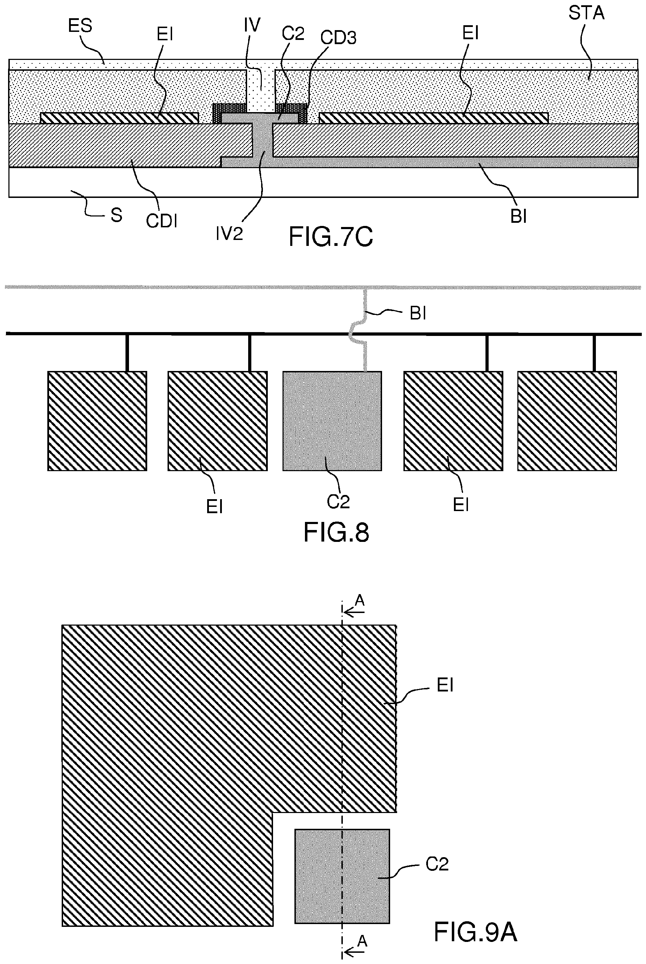

La figure 7C montre un dispositif semblable à celui des figures 7A et 7B dans lequel une couche diélectrique CD3 est utilisée pour éviter tout contact direct entre l'élément C2 et la structure active STA.

La figure 8 se rapporte au cas où une ou plusieurs électrodes inférieures El de la matrice active sont « sacrifiées » pour laisser la place à des éléments conducteurs C2. Dans l'exemple illustré sur la figure, un élément conducteur C2 isolé remplace une électrode El ; dans d'autres cas plusieurs éléments conducteurs peuvent remplacer plusieurs électrodes El contigües. Typiquement il y aura une zone de contact, formée par un ou plusieurs éléments C2 contigus, par paquet de 1.000 voire 10.000 pixels ou plus. La résistance entre l'électrode supérieure et les plots de reprise de contact sera d'autant plus faible que le nombre d'éléments C2 sera élevé, mais chaque élément C2 remplace une électrode inférieure et réduit donc l'efficacité de génération ou détection de lumière du dispositif matriciel. Des corrections logicielles pourront être avantageusement appliquées dans le traitement ultérieur de l'image afin de ne pas faire apparaitre dans l'image ces pixels « morts » de la matrice. Ces types de corrections sont connus de l'homme de l'art. Par exemple, le pixel sacrifié peut être remplacé par un pixel fictif présentant un niveau de courant correspondant à la moyenne des niveaux de courants lus sur ces plus proches voisins.

Un dispositif matriciel de ce type a été réalisé à partir d'une dalle en verre de (0,7 × 311,4 × 251,4mm) comportant une matrice active de dimensions 284,16mm × 230,88mm. Cette matrice est composée de TFT a-Si :H dont chacun est connecté à une électrode inférieure El dont la surface est en FTO (oxyde d'étain dopé fluor). Le pas de la matrice est de 150µm. A l'intérieur de la matrice est intégré un réseau secondaire formé des éléments C2 et des bus d'interconnexion Bl. Ces derniers sont parallèles aux colonnes, chaque bus étant connecté à une interconnexion verticale avec l'électrode supérieure. Chaque élément C2 remplace une électrode de la matrice active, obligeant donc à sacrifier un pixel. Les éléments C2 et les bus Bl sont constitués d'un bi-couche Cr/ITO d'épaisseur 100nm/20nm. Ensuite une couche de photoconversion STA a été déposée à la tournette dans un solvant de type chlorobenzène, avec une épaisseur sèche de 600nm après recuit thermique. Cette couche est un mélange nanostructuré entre un matériau donneur d'électron (PCDTBT) et un matériau accepteur d'électron ([60]PCBM) avec un rapport massique de 1 :1. Des vias ont été ouverts sur chaque pixel sacrificiel afin de pouvoir établir une zone de contact entre l'ITO de l'élément C2 et l'électrode supérieure. La surface d'ouverture des vias est supérieure à la surface non passivée des éléments C2 (Cr/ITO), afin d'éviter les injections parasites de porteurs dans la structure active. Les vias passent à travers la couche de photoconversion. Les vias ont été fabriqués par photolithographie, en utilisant une résine fluorée de type OSCoR4000 de chez Orthogonal. L'ouverture du via a été réalisée par gravure plasma (80mT, 100sccm O2, 400W, 1000s) de la couche de photoconversion. La résine a ensuite été enlevée dans un solvant spécifique (« stripper »). Ensuite, une couche de PEDOT-PSS a été déposée par filière en forme de fente sur la couche de photoconversion de manière à former l'électrode supérieure. La couche de PEDOT-PSS a une épaisseur de 1,1µm, une résistivité de 50Ω/□, et une transmittance de 73% à la longueur d'onde de 520 nm, correspondant à l'émission d'un scintillateur en CsI :TI ou Gadox. Le PEDOT-PSS vient contacter les éléments conducteurs C2 à travers les vias. Une encapsulation composée d'une colle barrière et d'un verre mince et ayant une épaisseur totale de 65µm a été laminée sur la surface du PEDOT-PSS de manière à recouvrir toute la surface couverte par les couches organiques (couche de photoconversion et couche de PEDOT-PSS). Un adhésif double face (épaisseur 30µm) a été laminé sur la surface du film barrière. Sur cet adhésif a été laminé un scintillateur de Csl :TI dont les fibres ont été faites croitre sur un substrat d'Aluminium. Une passivation des bords du substrat a été réalisée en déposant un cordon de silicone. Les plots de reprise de contact sur deux côtés de la dalle ont été connectés à une carte électronique type PCB comportant l'électronique de lecture de la matrice par l'intermédiaire de flexibles combinés à un adhésif de type ACF de manière à permettre l'acquisition d'une image numérique. Les figures 9A (vue par-dessus) et 9B (coupe A-A) illustrent le cas où un élément C2 empiète sur une portion - de préférence non supérieure à 20% voire 10% - de la surface d'une électrode inférieure. Plus particulièrement, l'élément C2 occupe une ouverture O située sur le bord de l'électrode inférieure.

Comme dans le cas des figures 6A - 6C et 7A - 7C il peut y avoir jusqu'à un élément C2 en correspondance de chaque pixel, mais de préférence il y aura plutôt un élément C2 par paquet de 1000, voire 10.000 pixels ou plus. La résistance entre l'électrode supérieure et les plots de reprise de contact sera d'autant plus faible que le nombre d'éléments C2 sera élevé, mais chaque élément C2 empiète sur la surface d'une électrode inférieure et réduit donc l'efficacité de génération ou détection de lumière du dispositif matriciel.

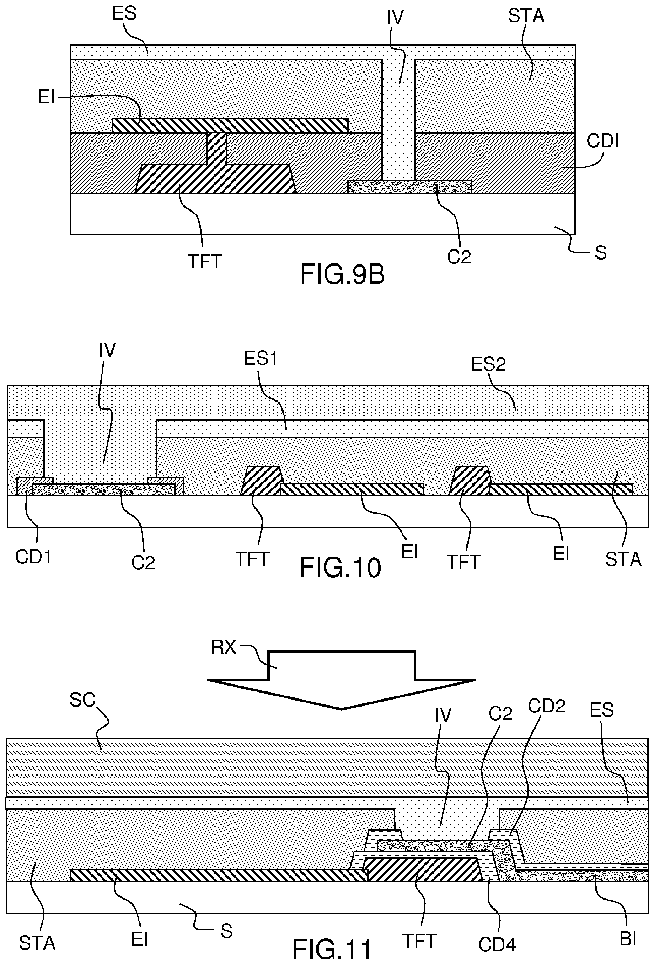

La figure 9B montre que les éléments conducteurs C2 (et les bus d'interconnexion Bl, non représentés) sont enterrés : ils sont déposés directement sur le substrat S, alors que les électrodes inférieures El et la structure active STA sont réalisés au-dessus d'une couche diélectrique CDI déposée par-dessus. Les transistors TFT sont réalisés directement sur le substrat, au-dessous des électrodes El respectives, de manière à ne pas empiéter sur leur surface.

Un dispositif matriciel de ce type a été réalisé à partir d'une dalle sur substrat plastique en PET de (0,125 × 311,4 × 251,4mm) comportant une matrice active de dimensions 284,16mm × 230,88mm. Cette matrice est composée de TFT organiques (OTFT) dont chacun est connecté à une électrode inférieure El dont la surface est en AZO (oxyde de zinc dopé aluminium). Le pas de la matrice est de 150µm. A l'intérieur de la matrice est intégré un réseau secondaire formé des éléments C2 et des bus BI. Ce réseau n'est pas connecté électriquement aux lignes et colonnes, mais est connecté à quatre plots de reprise de contact à l'extérieur de la matrice. Les bus Bl sont parallèles aux colonnes : il y en a un toutes les 100 colonnes et chacun est connecté à 3 interconnexions verticales IV avec l'électrode supérieure. Les éléments C2 et les bus Bl sont formés d'une couche d'Au d'épaisseur 100nm. Comme expliqué plus haut, ils sont localisés sur un niveau inférieur au niveau de l'électrode inférieure de la photodiode en AZO, les deux niveaux étant séparés par une couche tampon CDI en résine SU8 de 4µm d'épaisseur. De manière avantageuse, les électrodes source-drain (ou les électrodes de grille) des TFT ont été réalisées au même niveau. Pour réaliser les interconnexions verticales IV entre les éléments C2 et l'électrode supérieure ES en PEDOT-PSS, on a été amené à empiéter sur une partie de la surface de la dalle occupée par l'électrode inférieure de la photodiode en AZO. Ensuite une couche de photoconversion STA a été déposée par pulvérisation (« spray coating ») dans un solvant de type chlorobenzène, avec une épaisseur sèche de 800nm après recuit thermique. Cette couche est un mélange nanostructuré entre un matériau donneur d'électron (Poly[(4,8-bis-(2-ethylhexyloxy)-benzo(1,2-b:4,5-b')dithiophene)-2,6-diyl-alt-(4-(2-thylhexanoyl)- thieno[3,4-b]thiophene-)-2-6-diyl)], connu comme PBDTTT-C) et un matériau accepteur d'électron [6,6]-phényl-C71-butanoate de méthyle, connu comme [70]PCBM) avec un rapport massique de 1 :2. Des vias ont été ouverts afin de pouvoir établir un contact électrique entre l'Au des éléments C2 et l'électrode supérieure. Les vias passent à travers la couche de photoconversion et la résine diélectrique en SU8. Les vias ont été fabriqués par ablation laser à l'aide d'un laser excimère avec une longueur d'onde de 248nm et une énergie de 450mJ par impulsion. Ensuite, une couche de PEDOT-PSS mélangé à des nanofils d'Ag a été déposée en utilisant une racle (« doctor blade ») sur la couche de photoconversion pour former l'électrode supérieure. La couche de PEDOT-PSS mélangé à des nanofils d'Ag a une épaisseur de 4µm, une résistivité de 230Ω/□, et une transmittance de 88% à la longueur d'onde de 520 nm, correspondant à l'émission d'un scintillateur en Csl :TI ou Gadox. Le PEDOT-PSS vient contacter les éléments C2 à travers les vias. Une encapsulation composée d'un PSA barrière et d'un film barrière et ayant une épaisseur totale de 50µm a été laminée sur la surface du PEDOT-PSS de manière à recouvrir toute la surface couverte par les couches organiques (couche de photoconversion et couche de PEDOT-PSS). Un adhésif double face (épaisseur 30µm) a été laminé sur la surface du film barrière. Sur cet adhésif a été laminé un scintillateur en Gadox. Une passivation des bords du substrat a été réalisée en déposant un cordon de silicone. Les plots de reprise de contact sur deux côtés de la dalle ont été connectés à une carte électronique type PCB comportant l'électronique de lecture de la matrice par l'intermédiaire de flexibles combinés à un adhésif de type ACF de manière à permettre l'acquisition d'une image numérique. L'électrode supérieure peut aussi être réalisée sous forme d'une structure multicouche. La figure 10 montre une vue en coupe d'un dispositif du type de la figure 8 (éléments conducteurs C2 remplaçant des électrodes inférieures de pixels) présentant une électrode supérieure en deux couches, ES1 et ES2.

Un dispositif matriciel de ce type a été réalisé à partir d'une dalle en verre de (0,7 × 311,4 × 251,4mm) comportant une matrice active de dimensions 284,16mm × 230,88mm. Cette matrice est composée de TFT a-Si :H dont chacun est connecté à une électrode inférieure El dont la surface est en FTO (oxyde d'étain dopé fluor). Le pas de la matrice est de 150µm. A l'intérieur de la matrice est intégré un réseau secondaire formé des éléments C2 et des bus BI. Ce réseau n'est pas connecté électriquement aux lignes et colonnes, mais est connecté à quatre plots de reprise de contact à l'extérieur de la matrice. Les bus BI sont parallèles aux colonnes : il y en a un toutes les 100 colonnes et chacun est connecté à 3 interconnexions verticales IV avec l'électrode supérieure. Pour réaliser les interconnexions verticales, on a été amené à sacrifier des électrodes inférieures de pixels unitaires. Les éléments C2 et le bus d'interconnexion sont constitués d'un bi-couche Cr/ITO d'épaisseur 100nm/20nm. Ensuite une couche de photoconversion a été déposée à la tournette dans un solvant de type chlorobenzène, avec une épaisseur sèche de 600nm après recuit thermique. Cette couche est un mélange nanostructuré entre un matériau donneur d'électron (PCDTBT) et un matériau accepteur d'électron ([60]PCBM) avec un rapport massique de 1 :1. Une première couche ES1 de PEDOT de 100nm a été déposée sur la couche de photoconversion, à la tournette. Cette couche a une double fonction : d'une part, elle fait partie de l'électrode supérieure, et d'autre part, elle sert de couche tampon pour protéger la couche de photoconversion de la fabrication des vias. Ces vias ont été ouverts sur chaque pixel sacrificiel afin de pouvoir établir une zone de contact entre l'ITO des éléments C2 et la deuxième couche de l'électrode supérieure. La surface d'ouverture des vias est supérieure à la surface non passivée de l'élément C2 (Cr/ITO), afin d'éviter les injections parasites de porteurs dans la structure active. Les vias passent à travers la couche de photoconversion et la première couche de PEDOT. Les vias ont été fabriqués par photolithographie, en utilisant une résine fluorée de type OSCoR4000 de chez Orthogonal. L'ouverture des vias a été faite par gravure plasma (80mT, 100sccm O2, 400W, 1500s) de la couche de photoconversion. La résine a ensuite été enlevée dans un solvant spécifique (« stripper »). Ensuite un deuxième niveau conducteur ES2 est déposé par pulvérisation d'une couche d'ITO de 200nm d'épaisseur, une résistivité de 20Ω/□ et une transmittance supérieure à 90% à la longueur d'onde de 520 nm, correspondant à l'émission d'un scintillateur en Csl :TI ou Gadox. La deuxième couche de PEDOT-PSS vient contacter les éléments C2 à travers les vias. Une encapsulation composée d'une colle barrière et d'un verre mince et ayant une épaisseur totale de 65µm a été laminée sur la surface du PEDOT-PSS de manière à recouvrir toute la surface couverte par les couches organiques (couche de photoconversion et couches de PEDOT-PSS). Un adhésif double face (épaisseur 30µm) a été laminé sur la surface du film barrière. Sur cet adhésif a été laminé un scintillateur de Csl :TI dont les fibres ont été faites croitre sur un substrat d'Aluminium. Une passivation des bords du substrat a été réalisée en déposant un cordon de silicone. Les plots de reprise de contact sur deux côtés de la dalle ont été connectés à une carte électronique type PCB comportant l'électronique de lecture de la matrice par l'intermédiaire de flexibles combinés à un adhésif de type ACF de manière à permettre l'acquisition d'une image numérique..

La figure 11 montre, à titre d'illustration uniquement, une vue en coupe d'un dispositif matriciel du type des figures 6A et 6B, sur l'électrode supérieure duquel est rapporté un scintillateur SC émettant de la lumière lorsqu'il est éclairé par un rayonnement X RX, afin de réaliser un imageur X pour radiologie.

Plusieurs variantes de l'invention sont possibles.

Le nombre et les dimensions des éléments conducteurs C2 sont variables. Lorsque ces éléments sont à l'intérieur de la matrice active, leur surface unitaire est typiquement comprise entre 20µm² et 0,25mm². Si ces éléments remplacent des électrodes inférieures de pixels, on sacrifiera de préférence les pixels périphériques de la matrice.

La résistance de contact entre l'électrode supérieure, par exemple en PEDOT-PSS, et les éléments C2 doit être la plus faible possible afin de minimiser la chute ohmique liée au contact. La résistance de contact est de préférence inférieure à 100 Ω·cm² et de préférence inférieure à 5 Ω·cm². Les éléments C2 peuvent être réalisés avec tous type de conducteurs : métaux (AI, Cu, Ni, Ag, Au, pt, Cr, Ti, TiW...), oxydes conducteurs transparents (ITO, IZO, GZO, AZO, FTO...), nanofils métalliques (Ag, Au...), nanotubes de carbone, graphène... Ils peuvent être réalisés en un mélange ou un empilement de ces matériaux.

En ce qui concerne plus spécifiquement les oxydes conducteurs transparents, il convient de noter que leur utilisation pour réaliser l'électrode supérieure est généralement à proscrire à cause du risque important de dégradation de la structure active organique par les procédés de dépôt adaptées à ces matériaux, d'où l'utilisation d'un matériau moins conducteur comme le PEDOT-PSS. Par contre, l'utilisation d'oxydes conducteurs transparents pour réaliser les éléments C2 ne présente pas de contreindication. Par ailleurs, les oxydes conducteurs déposés sur une structure active semi-conductrice sont très résistifs, alors que leur conductivité est meilleure lorsqu'ils sont déposés sur un substrat isolant.

Dans le cas de l'empilement de couches, certaines peuvent apporter des propriétés d'adhésion (Ti, Cr,...), de conduction (AI, Cu, Au, Ag...), d'interface avec l'électrode supérieure (Au, ITO...), ... Les bus d'interconnexion BI sont réalisés à partir des mêmes matériaux. Ils présentent une épaisseur qui peut aller de 1nm à plusieurs dizaines de micromètres. de préférence, le bus a une épaisseur de 6nm à 20µm. De manière courante, lorsque le bus est un métal déposé sous vide, il a une épaisseur comprise entre 20nm et 300nm.

L'interface de chaque élément C2 avec l'électrode supérieure sera de préférence assurée par un matériau qui fait un bon contact électrique avec cette dernière. Par bon contact, on entend un contact le moins résistif possible. A cet effet un matériau d'interface avec des métaux de type ITO, Au, Ag, Pt, Pd sera bien appropriée dans le cas d'une électrode supérieure en PEDOT-PSS. De préférence, la couche d'interface sera en Au. Cette couche d'interface pourra avoir une épaisseur allant de 1 nm à plusieurs µm. Elle pourra être déposée par impression, par électrochimique, par dépôt sous vide type évaporation, pulvérisation...

La résistivité des éléments C2 est au plus égale à celle de la couche en PEDOT-PSS utilisée pour l'électrode supérieure, et de préférence au moins 10 fois, voire au moins 100 fois, plus faible que celle de la couche en PEDOT-PSS utilisée pour l'électrode supérieure.

Dans certains modes de réalisation (figures 5B, 6C, 7C) une couche diélectrique CD3 est utilisée pour éviter les injections parasites de porteurs dans la structure active. Cette couche peut être réalisée en un diélectrique inorganique, organique ou hybride (organique-inorganique) ou un empilement ou un mélange de ces types de matériaux. De manière courante, le diélectrique peut être une couche déposée par dépôt de couches atomiques (ALD, de l'anglais « Atomic Layer Déposition ») : Al2O3, , nanolaminates, ZrO2..., par pulvérisation ou évaporation (SiN, SiON, SiNx, SiOx, parylène...), ou par voie liquide (résine de photolithographie type S1818, SU8, BCB, polymère isolant type CYTOP^{®}, polystyrène, cyclooléfine, PMMA...). Il peut également être une couche auto-assemblée (SAM) à la surface des éléments C2 (ex : Octadecyltrichlorosilane). L'épaisseur de la couche diélectrique est typiquement comprise entre 0,5nm et 20µm.

Dans d'autres modes de réalisation (figure 5C) les injections parasites de porteurs dans la structure active sont évités grâce à l'utilisation d'un matériau des éléments C2 présentant un travail de sortie approprié pour éviter les injections de charges parasites dans la couche active. Lorsque le dispositif est polarisé de manière à assurer son fonctionnement normal (polarisation négative dans le cas d'une photodiode polarisée sur l'électrode d'anode), il se forme une barrière de potentiel entre l'élément C2 et la structure active STA empêchant l'injection de porteurs de l'élément C2 vers ladite structure STA. La hauteur de cette barrière doit être d'au moins 0,3 eV et de préférence d'au moins 0,5 eV. Plus particulièrement :
Si la structure active STA forme une photodiode et l'électrode supérieure ES est l'anode de cette photodiode, la barrière de potentiel entre l'élément C2 et la structure active doit être suffisante pour ne pas injecter d'électron de l'interconnexion vers la structure multicouche lorsque l'électrode supérieure est polarisée négativement et dans le noir.
- Si la structure active STA forme une photodiode et l'électrode supérieure ES est la cathode de cette photodiode, la barrière de potentiel entre l'élément C2 et la structure active doit être suffisante pour ne pas injecter de trous de l'interconnexion vers la structure multicouche lorsque l'électrode supérieure est polarisée positivement et dans le noir.

Des ouvertures, types vias, sont créées dans les niveaux entre l'électrode supérieure et les éléments C2, afin de pouvoir créer les zones de contact. Ces vias sont fabriqués par les techniques de microélectronique type photolithographie combinées aux techniques de gravures sèches (plasma) ou humides (dissolution), par ablation laser (laser excimère à 248nm, laser excimère à 308nm, laser YAG à 532nm, laser YAG à 1064nm), par poinçonnage mécanique, ou une combinaison de ces différentes techniques. Ils peuvent également être fabriqués suivant le procédé décrit dans le document FR2925222 ou toutes autres techniques connues de l'homme de l'art. Les dimensions des vias vont de 1µm² à plusieurs mm². De manière courante, les surfaces des vias sont de l'ordre de 100µm² à 25000µm².

La structure active STA peut être une couche en matériau organique, inorganiques ou en un mélange hybride organique-inorganique ou un empilement de couches organiques et/ou inorganiques et/ou hybrides. Elle a une épaisseur entre 20nm et 3mm. Dans, le cas de la détection indirecte de rayons X, elle a une épaisseur de l'ordre de 50 nm à 2µm. De préférence, cette structure est par exemple un mélange nanostructuré de deux semi-conducteurs organiques, un donneur d'électrons (P3HT RR, PCDTBT, PCPDTBT, PTAA, etc...), et un accepteur d'électrons (C60, C70, 60PCBM, 70PCBM, 80PCBM, ICBA, dérivé d'acène diimide, P(NDI2HD-T), etc.). Elle peut être déposée par voie liquide à partir des techniques d'impression (jet d'encre, sérigraphie, dépôt à la tournette, raclage, filière en forme de fente, héliographie, flexographie, pulvérisation, etc. Il peut également s'agir d'une couche de pérovskites hybrides organiques-inorganiques d'halogénure de plomb méthylammonium. Elle peut être déposée par voie liquide à partir des techniques d'impression (sérigraphie, dépôt à la tournette, raclage, filière en forme de fente, pulvérisation...). Des couches d'interfaces comme des couches pour caler le travail de sortie des électrodes ou des couches bloquantes aux trous et couches bloquantes aux électrons peuvent être insérées entre la couche de photoconversion et les deux électrodes (inférieure et supérieure).

L'électrode supérieure ES est avantageusement à base de PEDOT-PSS mais peut également être composée d'une couche ou d'un multicouche d'autres matériaux à base de PEDOT se différenciant par des propriétés telles quele type de dopants, le ratio de dopants, leur masse molaire, leur structure macromoléculaire, les additifs, solvants ou charges qu'ils contiennent, etc... Cette couche de l'ordre de 1nm à 10µm et peut être déposée par voie liquide à partir des techniques d'impression (jet d'encre, sérigraphie, dépôt à la tournette, raclage, filière en forme de fente, héliographie, flexographie, pulvérisation...). La couche a avantageusement une épaisseur de 300nm, pour une conductivité de 70Ω/□ et une transmittance de 83% à la longueur d'onde de 520nm.

L'invention s'applique également lorsque l'électrode supérieure est composée d'un ou plusieurs autres matériaux qui ne sont pas du PEDOT. Ces matériaux peuvent être de la polyaniline (PANI), un oxyde conducteur transparent (ITO, AZO, GZO...), un tri-couche à base d'oxydes métalliques (MoOx/Ag/MoOx, etc...), un réseau de nanofils conducteurs (Ag, Cu, Au...), un réseau de nanotubes de carbone, du graphène, un métal fin type Ag, Au, Al (1nm à 20nm).

Les électrodes inférieures définissent des pixels qui peuvent présenter des formes et dimensions variables avec, de préférence, une surface non supérieure à 0,25 mm².

## Revendications

1. Dispositif optoélectronique matriciel comprenant :
- un substrat (S) électriquement isolant portant, sur l'une de ses surfaces, une matrice (MEI) d'électrodes (El) dites inférieures ;
- une structure active (STA) agencée au-dessus de ladite matrice d'électrodes inférieures, adaptée pour détecter un rayonnement lumineux ;
- et au moins une électrode dite supérieure (ES) s'étendant de manière continue au-dessus de ladite structure active, ladite électrode supérieure étant transparente au rayonnement lumineux émis ou détecté par la structure active ;
comprenant également au moins un élément conducteur (C2) porté par le substrat sans interposition de ladite structure active et relié à ladite électrode supérieure par au moins une interconnexion verticale (IV), ledit élément conducteur présentant une résistivité électrique inférieure à celle de ladite électrode supérieure ;
dont ladite ou chaque dite interconnexion verticale est réalisée en un matériau présentant un travail de sortie de valeur adaptée pour que l'application, entre l'électrode supérieure et au moins les électrodes inférieures les plus proches de ladite interconnexion verticale, d'une différence de potentiel permettant à ladite structure active de détecter ledit rayonnement lumineux, provoque l'apparition d'une barrière de potentiel empêchant l'injection de charges électriques parasites vers lesdites électrodes inférieures à travers la structure active, **caractérisé en ce que**
la hauteur de la barrière de potentiel entre l'interconnexion verticale (IV) et la structure active (STA) est d'au moins 0,3eV ;
et **en ce que** :
- ladite interconnexion verticale traverse ladite structure active et est en contact directe avec celle-ci ; et
- ledit ou au moins un dit élément conducteur est agencé sur une région du substrat située à l'intérieur de ladite matrice d'électrodes inférieures.

2. Dispositif optoélectronique matriciel selon la revendication 1 dans lequel lesdites électrodes inférieures définissent des pixels de surface non supérieure à 0,25 mm².

3. Dispositif optoélectronique matriciel selon l'une des revendications précédentes comprenant également un transistor à couche mince (TFT) relié électriquement et adjacent à chaque dite électrode inférieure, ledit ou au moins un dit élément conducteur étant agencé au-dessus d'un dit transistor à couche mince, mais sans connexion électrique directe avec ce transistor.

4. Dispositif optoélectronique matriciel selon l'une des revendications précédentes dans lequel ledit ou au moins un dit élément conducteur est agencé dans une ouverture (O) pratiquée dans une dite électrode inférieure, ladite ouverture présentant une surface non supérieure à 10% de celle de l'électrode inférieure.

5. Dispositif optoélectronique matriciel selon l'une des revendications précédentes dans lequel ledit ou au moins un dit élément conducteur (C2) remplace au moins une dite électrode inférieure (E1) de la matrice.

6. Dispositif optoélectronique matriciel selon l'une des revendications précédentes dans lequel lesdites électrodes inférieures (E1) sont portées par une couche diélectrique (CDI) déposée sur ledit substrat, tandis que ledit ou au moins un dit élément conducteur (C2) est agencé au-dessous de ladite couche diélectrique.

7. Dispositif optoélectronique matriciel selon l'une des revendications précédentes dans lequel ladite ou au moins une dite interconnexion verticale (IV) présente une extension latérale plus grande que l'élément conducteur (C2) correspondant, de manière à le séparer de ladite structure active.

8. Dispositif optoélectronique matriciel selon l'une des revendications précédentes dans lequel ledit ou au moins un dit élément conducteur (C2) est recouvert d'une couche diélectrique (CD1, CD2), en dehors de ladite interconnexion verticale, de manière à le séparer de ladite structure active.

9. Dispositif optoélectronique matriciel selon l'une des revendications précédentes dans lequel ledit ou au moins un dit élément conducteur ( C2) est réalisé en un matériau présentant un travail de sortie de valeur adaptée pour provoquer l'apparition d'une barrière de potentiel avec ladite structure active lorsque ladite différence de potentiel est appliquée entre l'électrode supérieure et lesdites électrodes inférieures, cette barrière de potentiel entre l'élément conducteur (C2) et la structure active (STA) étant d'au moins 0,3 eV.

10. Dispositif optoélectronique matriciel selon l'une des revendications précédentes, comprenant une pluralité de dits éléments conducteurs (C2) reliés entre eux par un bus (BI).

11. Dispositif optoélectronique matriciel selon l'une des revendications précédentes, dans lequel ladite structure active (STA) s'étend de manière continue au-dessus de ladite matrice d'électrodes inférieure (E1) et comprend au moins une couche contenant au moins un matériau organique.

12. Dispositif optoélectronique matriciel selon la revendication 11 dans lequel ladite électrode supérieure (ES) est à base de PEDOT.

13. Dispositif optoélectronique matriciel selon l'une des revendications précédentes dans lequel ladite ou au moins une dite interconnexion verticale (IV) est réalisée avec le même matériau que l'électrode supérieure.

14. Dispositif optoélectronique matriciel selon l'une des revendications précédentes, dans lequel ladite structure active (STA) est une structure de photoconversion, coopérant avec lesdites électrodes supérieures et inférieures pour former un dispositif photodiode et créer ainsi une matrice de photodétecteurs.

15. Dispositif optoélectronique matriciel selon la revendication précédente comprenant également une couche en matériau scintillateur (SC) fixée au-dessus de ladite électrode supérieure (ES), de manière à constituer un imageur à rayons X.

## Patentansprüche

1. Optoelektronische Matrixvorrichtung, die Folgendes umfasst:
- ein elektrisch isolierendes Substrat (S), das auf einer seiner Oberflächen eine Matrix (MEI) aus sogenannten unteren Elektroden (El) trägt;
- eine aktive Struktur (STA), die über der Matrix aus unteren Elektroden angeordnet und zum Erfassen von Lichtstrahlung geeignet ist;
- und mindestens eine sogenannte obere Elektrode (ES), die sich kontinuierlich über die aktive Struktur erstreckt, wobei die obere Elektrode für von der aktiven Struktur ausgesendete oder erfasste Lichtstrahlung transparent ist;
die auch mindestens ein leitendes Element (C2) umfasst, das von dem Substrat ohne Einfügung der aktiven Struktur getragen wird und mit der oberen Elektrode durch mindestens eine vertikale Verbindung (IV) verbunden ist, wobei das leitende Element einen geringeren elektrischen Widerstand als die obere Elektrode aufweist;
von dem die oder jede vertikale Verbindung aus einem Material mit einem solchen Austrittsarbeitswert besteht, dass das Anlegen einer Potenzialdifferenz zwischen der oberen Elektrode und mindestens den der vertikalen Verbindung am nächsten liegenden unteren Elektroden, die die aktive Struktur zulässt, die Lichtstrahlung zu erfassen, die Entstehung einer Potentialbarriere bewirkt, die ein Einspeisen von parasitären elektrischen Ladungen in die unteren Elektroden durch die aktive Struktur verhindert, **dadurch gekennzeichnet, dass** die Höhe der Potentialbarriere zwischen der vertikalen Verbindung (IV) und der aktiven Struktur (STA) mindestens 0,3eV beträgt;
und dadurch, dass:
- die vertikale Verbindung durch die aktive Struktur verläuft und in direktem Kontakt damit steht; und
- das oder mindestens ein(e) leitende(s) Element auf einer Region des Substrats angeordnet ist, die sich innerhalb der Matrix aus unteren Elektroden befindet.

2. Optoelektronische Matrixvorrichtung nach Anspruch 1, wobei die unteren Elektroden Pixel mit einer Fläche von nicht mehr als 0,25 mm² definieren.

3. Optoelektronische Matrixvorrichtung nach einem der vorhergehenden Ansprüche, die auch einen Dünnschichtransistor (TFT) umfasst, der elektrisch verbunden ist und an jede untere Elektrode angrenzt, wobei das oder mindestens ein(e) leitende(s) Element über dem Dünnschichttransistor angeordnet ist, aber keine direkte elektrische Verbindung mit diesem Transistor hat.

4. Optoelektronische Matrixvorrichtung nach einem der vorhergehenden Ansprüche, wobei das oder mindestens ein(e) leitende(s) Element in einer Öffnung (O) in einer unteren Elektrode angeordnet ist, wobei die Öffnung eine Fläche von nicht mehr als 10 % von der der unteren Elektrode aufweist.

5. Optoelektronische Matrixvorrichtung nach einem der vorhergehenden Ansprüche, wobei das oder mindestens ein(e) leitende(s) Element (C2) mindestens eine untere Elektrode (E1) der Matrix ersetzt.

6. Optoelektronische Matrixvorrichtung nach einem der vorhergehenden Ansprüche, wobei die unteren Elektroden (E1) von einer auf das Substrat aufgebrachten dielektrischen Schicht (CDI) getragen werden, während das oder mindestens ein(e) leitende(s) Element (C2) unterhalb der dielektrischen Schicht angeordnet ist.

7. Optoelektronische Matrixvorrichtung nach einem der vorhergehenden Ansprüche, wobei die oder mindestens eine vertikale Verbindung (IV) eine seitliche Ausdehnung aufweist, die größer ist als die des entsprechenden leitenden Elements (C2), um es von der aktiven Struktur zu trennen.

8. Optoelektronische Matrixvorrichtung nach einem der vorhergehenden Ansprüche, wobei das oder mindestens ein(e) leitende(s) Element (C2) außerhalb der vertikalen Verbindung mit einer dielektrischen Schicht (CD1, CD2) bedeckt ist, um es von der aktiven Struktur zu trennen.

9. Optoelektronische Matrixvorrichtung nach einem der vorhergehenden Ansprüche, wobei das oder mindestens ein(e) leitende(s) Element (C2) aus einem Material mit einem solchen Austrittsarbeitswert besteht, dass eine Potentialbarriere mit der aktiven Struktur entsteht, wenn die Potentialdifferenz zwischen der oberen Elektrode und den unteren Elektroden angelegt wird, wobei diese Potentialbarriere zwischen dem leitenden Element (C2) und der aktiven Struktur (STA) mindestens 0,3 eV beträgt.

10. Optoelektronische Matrixvorrichtung nach einem der vorhergehenden Ansprüche, die eine Vielzahl von leitenden Elementen (C2) umfasst, die durch einen Bus (BI) miteinander verbunden sind.

11. Optoelektronische Matrixvorrichtung nach einem der vorhergehenden Ansprüche, wobei sich die aktive Struktur (STA) kontinuierlich über die Matrix aus unteren Elektroden (E1) erstreckt und mindestens eine Schicht umfasst, die mindestens ein organisches Material enthält.

12. Optoelektronische Matrixvorrichtung nach Anspruch 11, wobei die obere Elektrode (ES) auf PEDOT basiert.

13. Optoelektronische Matrixvorrichtung nach einem der vorhergehenden Ansprüche, wobei die oder mindestens eine vertikale Verbindung (IV) aus demselben Material wie die obere Elektrode hergestellt ist.

14. Optoelektronische Matrixvorrichtung nach einem der vorhergehenden Ansprüche, wobei die aktive Struktur (STA) eine Photokonversionsstruktur ist, die mit der oberen und unteren Elektrode zusammenwirkt, um eine Photodiodenvorrichtung zu bilden und dadurch eine Matrix von Photodetektoren zu schaffen.

15. Optoelektronische Matrixvorrichtung nach dem vorhergehenden Anspruch, die auch eine Schicht aus Szintillatormaterial (SC) umfasst, die über der oberen Elektrode (ES) befestigt ist, um einen Röntgenbildgeber zu bilden.

## Claims

1. A matrix-array optoelectronic device comprising:
- an electrically insulating substrate (S) bearing, on one of its surfaces, a matrix array (MEI) of so-called bottom electrodes (EI);
- an active structure (STA) arranged above said matrix-array of bottom electrodes, and suitable for detecting light radiation;
- and at least one so-called upper electrode (ES) extending continuously above said active structure, said upper electrode being transparent to the light radiation emitted or detected by the active structure;
also comprising at least one conductive element (C2) that is borne by the substrate without interposition of said active structure and that is connected to said upper electrode by at least one vertical interconnection (IV), said conductive element having an electrical resistivity lower than that of said upper electrode;
of which said or each said vertical interconnection is made of a material having a work function of value adapted so that the application, across the upper electrode and at least the bottom electrodes that are closest to said vertical interconnection, of a potential difference that allows said active structure to detect said light radiation, causes the appearance of a potential barrier that prevents the injection of parasitic electrical charge into said bottom electrodes through the active structure, **characterised in that** the height of the potential barrier between the vertical interconnection (IV) and the active structure (STA) is at least 0.3 eV;
and **in that**:
- said vertical interconnection passes through and is in direct contact with said active structure; and
- said or at least one said conductive element is arranged on a substrate region that is located within said matrix-array of bottom electrodes.

2. The matrix-array optoelectronic device according to claim 1, wherein said bottom electrodes define pixels with a surface area no larger than 0.25 mm².

3. The matrix-array optoelectronic device according to one of the preceding claims, also comprising a thin-film transistor (TFT) that is electrically connected and adjacent to each said bottom electrode, said or at least one said conductive element being arranged above a said thin-film transistor, but without direct electrical connection with this transistor.

4. The matrix-array optoelectronic device according to one of the preceding claims, wherein said or at least one said conductive element is arranged in an aperture (O) in a said lower electrode, said aperture having a surface area no larger than 10% of the surface area of the bottom electrode.

5. The matrix-array optoelectronic device according to one of the preceding claims, wherein said or at least one said conductive element (C2) replaces at least one said bottom electrode (E1) of the matrix.

6. The matrix-array optoelectronic device according to one of the preceding claims, wherein said bottom electrodes (E1) are borne by a dielectric layer (CDI) that is deposited on said substrate, whereas said or at least one said conductive element (C2) is arranged below said dielectric layer.

7. The matrix-array optoelectronic device according to one of the preceding claims, wherein said or at least one said vertical interconnection (IV) has a larger lateral extent than that of the corresponding conductive element (C2), so as to separate it from said active structure.

8. The matrix-array optoelectronic device according to one of the preceding claims, wherein, beyond said vertical interconnection, said or at least one said conductive element (C2) is covered with a dielectric layer (CD1, CD2), so as to separate it from said active structure.

9. The matrix-array optoelectronic device according to one of the preceding claims, wherein said or at least one said conductive element (C2) is made of a material having a work function of value adapted to cause the appearance of a potential barrier with said active structure when said potential difference is applied across the upper electrode and said bottom electrodes, this potential barrier between the conducting element (C2) and the active structure (STA) being at least 0.3 eV.

10. The matrix-array optoelectronic device according to one of the preceding claims, comprising a plurality of said conductive elements (C2) connected together by a bus (BI).

11. The matrix-array optoelectronic device according to one of the preceding claims, wherein said active structure (STA) extends continuously above said matrix array of bottom electrodes (E1) and comprises at least one layer containing at least one organic material.

12. The matrix-array optoelectronic device according to claim 11, wherein said upper electrode (ES) is based on PEDOT.

13. The matrix-array optoelectronic device according to one of the preceding claims, wherein said or at least one said vertical interconnection (IV) is made of the same material as the upper electrode.

14. The matrix-array optoelectronic device according to one of the preceding claims, wherein said active structure (STA) is a photoconverting structure that cooperates with said upper and bottom electrodes to form a photodiode device and to thus create a matrix array of photodetectors.

15. The matrix-array optoelectronic device according to the preceding claim, also comprising a layer (SC) made of scintillator material, said layer being fastened above said upper electrode (ES), so as to form an x-ray imager.
